# EUROPÄISCHE PATENTANMELDUNG

(11) **EP 3 208 621 A1**
(43) Veröffentlichungstag der Anmeldung: **23.08.2017**
(21) Anmeldenummer: 16156305.1
(22) Anmeldetag: 18.02.2016
(51) Int. Cl.: G01R 31/02, H02M 7/483, G01R 31/40, G01R 31/04, H02M 1/00, H04B 3/46

(54) **KABELBRUCH BEI MODULAREN SYSTEMEN**

(71) Anmelder: Siemens Aktiengesellschaft, 80333 München (DE)
(72) Erfinder: Blum, Manuel, 85521 Ottobrunn (DE); Galek, Marek, 82398 Polling (DE)

(57) **Zusammenfassung**

Ein Kabelbruch eines Versorgungsbusses bei einem modularen System soll zielgerichteter erkannt werden. Dazu wird ein verteiltes, modulares, elektronisches System mit mehreren Modulen (M1 bis M4) und einer Steuerungseinheit (MC) vorgeschlagen. Außerdem besitzt das System einen ringförmigen Versorgungsbus (B1 bis B4) zur Versorgung der Module (M1 bis M4) mit einer Hilfsspannung. Jedes der Module (M1 bis M4) weist einen Spannungsmesser (V) auf, der an den Versorgungsbus angeschlossen ist und mit dem ein Spannungswert der Hilfsspannung am jeweiligen Modul erfassbar ist. Jedes Modul (M1 bis M4) ist dazu ausgebildet, den jeweiligen Spannungswert an die Steuerungseinheit (MC) zu übertragen. Die Steuerungseinheit (MC) ihrerseits ist dazu ausgebildet, anhand der Spannungswerte der Module festzustellen, ob ein Kabel (K1 bis K5) des Versorgungsbusses gebrochen ist.

## Beschreibung

Die vorliegende Erfindung betrifft ein modulares, elektronisches System mit mehreren Modulen und einer Steuerungseinheit. Darüber hinaus betrifft die vorliegende Erfindung ein Verfahren zum Betreiben eines derartigen modularen, elektronischen Systems. Insbesondere bezieht sich die Erfindung auch auf einen modularen Mehrpunktstromrichter.

Häufig werden elektronische Systeme modular ausgebaut. Der Grund hierfür kann in der Flexibilität, in der verarbeiteten Leistung, der eingesetzten Spannung etc. liegen.

Ein konkretes Beispiel für modulare Systeme sind sogenannte modulare Mehrpunktstromrichter (Modular Multilevel Converter: M2C). Solche modulare Mehrpunktstromrichter können beispielsweise für Hochspannungs-Gleichstrom-Übertragungen (HGÜ) eingesetzt werden. Sie eignen sich aber ebenso für Mittelspannungs- und Niedervoltanwendungen.

Der modulare Aufbau solcher Systeme bedingt, dass die einzelnen Module in geeigneter Weise angesteuert werden müssen. Dazu kann jedes Modul einzeln mit einem separaten Kabel angesprochen werden. Alternativ hierzu können die Module des Systems aber auch durch einen Versorgungs- und/oder Kommunikationsbus vernetzt sein. Dieser Bus stellt dann die Schnittstelle zwischen einer zentralen Versorgungs- bzw. Steuerungseinheit und den einzelnen Modulen dar. Dabei kann jedes Modul in Abhängigkeit von seiner Funktion beziehungsweise seines Aufbaus einen Aktor, eine Zelle oder dergleichen darstellen.

Der Versorgungs- bzw. Kommunikationsbus kann zur Absicherung beziehungsweise Redundanz als Ringbus ausgeführt werden. Durch diesen Ring wird ein Ausfall des Systems beispielsweise bei einem Kabelbruch vermieden. Kommt es zu einem Kabelbruch, so bleibt die Funktion des Versorgungs- bzw. Kommunikationsbusses dennoch erhalten. Die Redundanz ist in einem solchen Fall allerdings nicht mehr gegeben.

Bislang war man darauf angewiesen, die Redundanz, die mit einem Ringbus erreicht werden kann, beispielsweise durch einen regelmäßigen Service zu kontrollieren. Alternativ konnten die Redundanz auch beispielsweise während einer Wartung aufwendig überprüft werden.

Die Aufgabe der vorliegenden Erfindung besteht somit darin, ein modulares elektronisches System vorzuschlagen, dessen ringförmiger Versorgungsbus im Hinblick auf einen Kabelbruch einfacher analysiert werden kann. Darüber hinaus soll ein entsprechendes Verfahren zum Betreiben eines solchen elektronischen Systems vorgeschlagen werden.

Erfindungsgemäß wird diese Aufgabe gelöst durch ein verteiltes, modulares, elektronisches System mit
- mehreren Modulen und
- einer Steuerungseinheit, sowie umfassend
- einen ringförmigen Versorgungsbus zur Versorgung der Module mit einer Hilfsspannung , wobei
- jedes der Module einen Spannungsmesser aufweist, der an den Versorgungsbus angeschlossen ist und mit dem ein Spannungswert der Hilfsspannung am jeweiligen Modul erfassbar ist,
- jedes Modul dazu ausgebildet ist, den jeweiligen Spannungswert an die Steuerungseinheit zu übertragen, und
- die Steuerungseinheit dazu ausgebildet ist, anhand der Spannungswerte der Module festzustellen, ob ein Kabel des Versorgungsbusses gebrochen ist.

Darüber hinaus wird erfindungsgemäß bereitgestellt ein Verfahren zum Betreiben eines verteilten, modularen, elektronischen Systems mit mehreren Modulen, einer Steuerungseinheit und einen ringförmigen Versorgungsbus durch
- Liefern einer Hilfsspannung an die Module über den Versorgungsbus,
- Erfassen eines Spannungswerts der Hilfsspannung an jedem Modul,
- Übertragen des jeweiligen Spannungswerts von jedem Modul an die Steuerungseinheit und
- Feststellen mittels der Steuerungseinheit anhand der Spannungswerte der Module, ob ein Kabel des Versorgungsbusses gebrochen ist.

In vorteilhafter Weise wird also die spezifische Struktur des Systems abwechselnd mit Kabeln und Modulen im Zusammenspiel mit der Tatsache, dass jedes Modul einen Spannungsmesser aufweist, genutzt, um mit entsprechenden Spannungswerten Aussagen über den Zustand des Versorgungsbusses treffen zu können. Da nämlich sämtliche Module mit einer Hilfsspannung über den Ringbus versorgt werden, diese also in Reihe geschaltet sind, fällt über jedes Modul eine spezifische Spannung ab. Dieser jeweils spezifische Spannungsabfall ist von vorne herein eine feste Größe für das modulare System. Dementsprechend kann eine zentrale Steuerungseinheit anhand der von den Modulen erhaltenen Spannungswerte selbständig feststellen, ob eine Irritation vorliegt. In einem solchen Fall kann gezielt eine Untersuchung des Systems eingeleitet werden. Dabei und auch für andere Zwecke kann der Versorgungsbus ebenso für die Kommunikation von Daten verwendet werden. Speziell können die Spannungswerte über den Versorgungsbus, der dann auch als Kommunikationsbus fungiert, an die Steuerungseinrichtung übertragen werden.

Bei dem modularen System handelt sich insbesondere um ein sogenanntes verteiltes System. "Verteilt" bedeutet hier, dass nicht nur die zentrale Steuerungseinheit "Intelligenz" besitzt und Steuerungsfunktion übernimmt, sondern auch die einzelnen Module.

Vorzugsweise ist die Steuerungseinheit dazu ausgelegt, durch Vergleich eines oder mehrerer der Spannungswerte der Module mit einem Sollwert festzustellen, ob das Kabel gebrochen ist. So kann beispielsweise für jedes Modul ein eigener Spannungswert in der Steuerungseinheit hinterlegt sein, der mit dem aktuell gemessenen Wert des jeweiligen Moduls verglichen wird. Liegt dann eine Diskrepanz zwischen mindestens einem der Wertepaare vor, so kann von einem Kabelbruch ausgegangen werden.

Bei einer weiteren bevorzugten Ausgestaltung ist die Steuerungseinheit dazu ausgelegt, durch Vergleich der mehreren Spannungswerte mit mehreren Sollwerten festzustellen, an welcher Stelle des Versorgungsbusses ein Kabelbruch vorliegt. Sämtliche Module des Systems besitzen nämlich festgelegte elektrische Eigenschaften, sodass sich an sämtlichen Modulen entsprechende, vorab bekannte Sollwerte der Spannung der Hilfsspannungsversorgung ergeben. So sinkt beispielsweise bei einem intakten System die Spannung schrittweise von Modul zu Modul ausgehend von der zentralen Versorgung bis zur Mitte des ringförmigen Versorgungsbusses. Von dort steigt die Spannung von Modul zu Modul wieder schrittweise an, bis die Steuerungseinheit erreicht ist. Bei einem Kabelbruch, der nicht in der Mitte des Versorgungsbusses vorliegt, ergibt sich eine entsprechende Verschiebung der Symmetrie der Spannungswerte. Bei einem Kabelbruch in der Mitte des Versorgungsbusses sinken die Absolutwerte der Spannungen an den einzelnen Modulen. In jedem Fall kann durch die spezifischen Größen der Spannungswerte ziemlich genau vorhergesagt werden, wo der Kabelbruch im Versorgungsbus vorliegt.

Gegebenenfalls ist die Steuerungseinheit auch dazu ausgebildet, die Hilfsspannung für die Module bereitzustellen. In diesem Fall bedarf es keiner separaten Spannungsquelle.

In einer Weiterbildung erfolgt der Vergleich der gemessenen Spannungswerte mit dem oder den Sollwerten unter Berücksichtigung eines jeweiligen Toleranzbands. Auf diese Weise wird dem System zugestanden, dass in der Spannungsversorgung oder in den verwendeten Bauteilen gewisse Schwankungen vorliegen. Die Steuerungseinheit kann dazu ausgelegt sein, durch Vergleich eines oder mehrerer der Spannungswerte der Module mit einem Schwellwert festzustellen, ob das Kabel gebrochen ist. So kann auf einfache Weise ein Überschreiten oder ein Unterschreiten eines vorher definierten Schwellwerts genutzt werden, um eine Aussage über den Zustand des Versorgungsbusses zu erhalten.

In ähnlicher Weise, wie oben mit Sollwerten gearbeitet wurde, kann die Steuerungseinheit des Systems auch dazu ausgelegt sein, durch Vergleich der mehreren Spannungswerte mit mehreren Schwellwerten festzustellen, an welcher Stelle des Versorgungsbusses ein Kabelbruch vorliegt. Dabei wird also bei mehreren Modulen festgestellt, ob ein jeweiliger Schwellwert für die Spannung über- beziehungsweise unterschritten ist und aus diesen etwaigen Abweichungen wird dann auf die Position des Kabelbruchs innerhalb des Versorgungsbusses geschlossen.

In einer konkreten Ausgestaltung kann der ringförmige Versorgungsbus durch eine abwechselnde Folge von Kabeln und Modulen realisiert sein, in die anstelle eines Moduls die Steuerungseinheit eingefügt ist. Dabei entspricht also die Anzahl der Kabel genau der Anzahl der Module zusammen mit der Steuerungseinheit. Bei einem derartigen Aufbau kann ein Kabelbruch sehr sicher geortet werden.

Vorzugsweise sind alle Module untereinander und alle Kabel untereinander gleich. Damit ergibt sich ein festes Aufbauschema, für das nicht individuell Sollwerte oder Schwellwerte für die Modulspannungen festgelegt werden müssen. Bei unterschiedlich großen Systemen können die einzelnen Werte unter Umständen sogar rechnerisch festgelegt werden.

Das modulare elektronische System kann beispielsweise als modularer Mehrpunktstromrichter ausgebildet sein. In diesem Fall beinhaltet ein Modul beispielsweise eine Halbbrücke mit einem Kondensator als Spannungsquelle für den Leistungskreis. Gerade Mehrpunktstromrichter mit einer hohen Zahl an Modulen beispielsweise zum Verarbeiten von Hochspannungen können dann von der erfindungsgemäßen Technik, einen Kabelbruch automatisiert festzustellen, profitieren.

Die oben im Zusammenhang mit dem System geschilderten funktionellen Merkmale können auch als Verfahrensschritte für das erfindungsgemäße Verfahren interpretiert werden.

Die vorliegende Erfindung wird nun anhand der beigefügten Zeichnungen näher erläutert, in denen zeigen:
- FIG 1: die Architektur eines verteilten, modularen, elektronischen Systems anhand eines modularen Mehrpunktstromrichters;
- FIG 2: ein Prinzipschaltbild eines ringförmigen Versorgungs- bzw. Kommunikationsbusses eines intakten modularen Systems; und
- FIG 3: das Schaltbild von FIG 2 mit einem gebrochenen Kabel.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in den geschilderten Kombinationen, sondern auch in Alleinstellung oder in anderen technisch sinnvollen Kombinationen realisierbar sind.

Ein verteiltes, modulares, elektronisches System weist eine Vielzahl von Modulen und mindestens eine Steuereinheit auf. Die Module sind über einen oder mehrere Versorgungs- bzw. Kommunikationsbusse mit einer zentralen Steuereinheit verbunden. Derartige verteilte Systeme können im Anlagenbau zahlreiche Anwendungen finden. Dabei kann jedes Modul einen Aktor (z.B. einen Leistungsschalter) aufweisen, der eine elektrische Funktionalität besitzt.

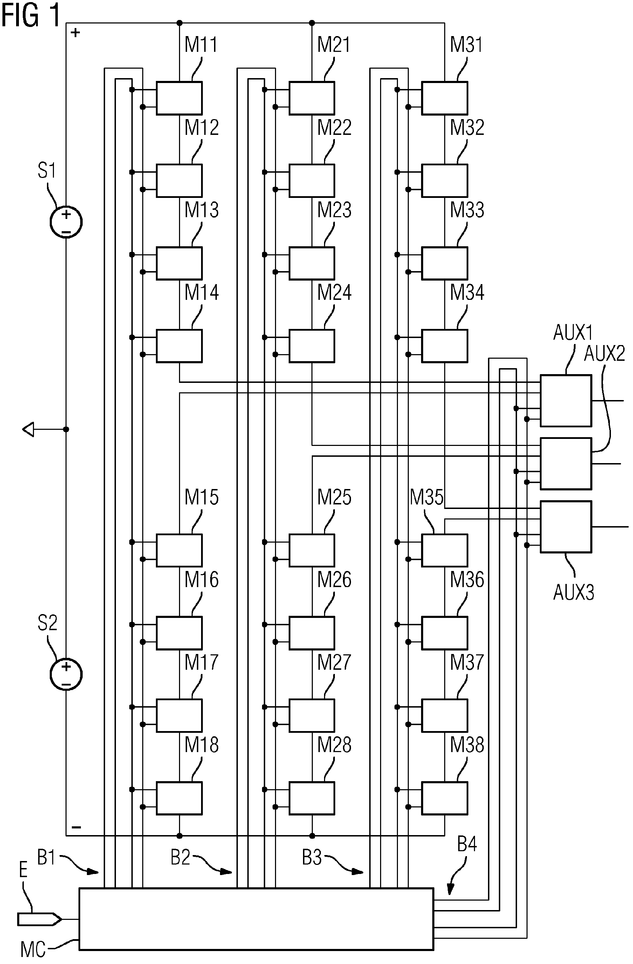

In dem Beispiel von FIG 1 ist ein modulares System dargestellt, welches als modularer Mehrpunktstromrichter realisiert ist. Ein solcher Stromrichter dient beispielsweise zum Gleichrichten eines Drehstroms in einem Gleichstrom, wie es beispielsweise für HGÜ-Übertragungen notwendig ist. Der dargestellte Stromrichter kann aber auch am anderen Ende der HGÜ-Leitung zum Wandeln von Gleichstrom in Drehstrom eingesetzt werden. Das Systemkonzept der modularen Mehrpunktstromrichter ist aber auch für Umrichter verwendbar.

Der in FIG 1 wiedergegebene Mehrpunktstromrichter besitzt eine Vielzahl an Modulen, die strangweise miteinander verknüpft sind. In einem ersten Strang befinden sich die Module M11 bis M18, in einem zweiten Strang die Module M21 bis M28 und in einem dritten Strang die Module M31 bis M38. Alle Module besitzen in der Regel gleichen Aufbau. Jeweils vier der Module in einem Strang sind bezogen auf ihren Leistungspfad in Serie geschaltet.

Zwei Gleichspannungsquellen S1 und S2 sind im vorliegenden Beispiel in Serie geschaltet, und durch diese Serienschaltung wird eine Plusschiene "+" und eine Minusschiene "-" symmetrisch mit Gleichspannung gespeist.

Die drei Modulserienschaltungen M11 bis M14, M21 bis M24 und M31 bis M34 sind einerseits an die Plusschiene angeschlossen und andererseits mit einer jeweiligen Hilfseinheit AUX1, AUX2 und AUX3 verbunden. Symmetrisch dazu sind die Modulserienschaltungen M15 bis M18, M25 bis M28 und M35 bis M38 einerseits mit der Minusschiene verbunden und andererseits mit den Hilfseinheiten AUX1, AUX2 und AUX3. Konkret führen also die Leistungspfade der Module M14 und M15 in die Hilfseinheit AUX1, die Leistungspfade der Module M24 und M25 in die Hilfseinheit AUX2 und die Leistungspfade der Module M34 und M35 in die Hilfseinheit AUX3. Jede der Hilfseinheiten AUX1, AUX2 und AUX 3 vereint die jeweiligen Leistungspfade und produziert eine Phase eines Drehstromsystems. Damit wäre ein Wechselrichter realisiert.

Alternativ kann der Stromrichter, wie oben erwähnt, auch dazu ausgebildet sein, dass er in umgekehrter Richtung einen dreiphasigen Strom in einen Gleichstrom wandelt. In diesem Fall kann er als Gleichrichter genutzt werden.

Die Steuerung des Stromrichters erfolgt mit einer Steuereinheit MC. Diese Steuereinheit MC steuert hier nicht nur sämtliche Module, sondern auch die Hilfseinheiten AUX1, AUX2 und AUX3. Mit einem ersten Bus B1 werden die Module M11 bis M18, mit einem zweiten Bus B2 die Module M21 bis M28, mit einem dritten Bus B3 die Module M31 bis M38 und mit einem vierten Bus B4 die Hilfseinheiten AUX1 bis AUX3 gesteuert. Jeder dieser Busse B1 bis B4 verfügt nicht nur über mindestens eine Datenleitung, sondern auch über mindestens eine Hilfsspannungsleitung. Über die jeweilige Datenleitung werden gegebenenfalls bidirektional Daten transportiert. Ebenfalls werden die einzelnen Module von der Steuereinheit MC mit Steuerdaten versorgt. Gegebenenfalls werden Zustandsdaten wie etwa Spannungen, Temperaturwerte und dergleichen, zurück an die Steuereinheit MC geliefert.

Über die Hilfsspannungsleitungen der Busse B1 bis B4 werden sowohl die Module als auch die Hilfseinheiten von der Steuereinheit MC oder einer anderen Quelle mit einer Hilfsspannung versorgt, die die jeweiligen aktiven Bauelemente für den Betrieb brauchen. Die Steuereinheit MC besitzt gegebenenfalls noch einen Eingang E für externe Befehle. In einer Weiterbildung sind die Hilfsspannungsleitungen und die Datenleitungen zusammengelegt, d.h. die Leitungen übertragen nicht nur Versorgungsenergie, sondern auch Daten. Unter Umständen ist das Leitungssystem als Versorgungsbus oder Kommunikationsbus ausgelegt.

Der Stromrichter von FIG 1 ist rein exemplarisch. Der prinzipielle Aufbau könnte auch für einen einphasigen Stromrichter oder einen anderen mehrphasigen Stromrichter genutzt werden. Auch muss an den Zwischenkreis nicht eine symmetrische Spannung vorliegen, sodass jeder Strang nicht symmetrisch zweigeteilt sein muss wie in dem Beispiel von FIG 1. In diesem Fall können dann auch gegebenenfalls die Hilfseinheiten AUX1 bis AUX3 entfallen. Auch die Anzahl der Module pro Strang kann variieren.

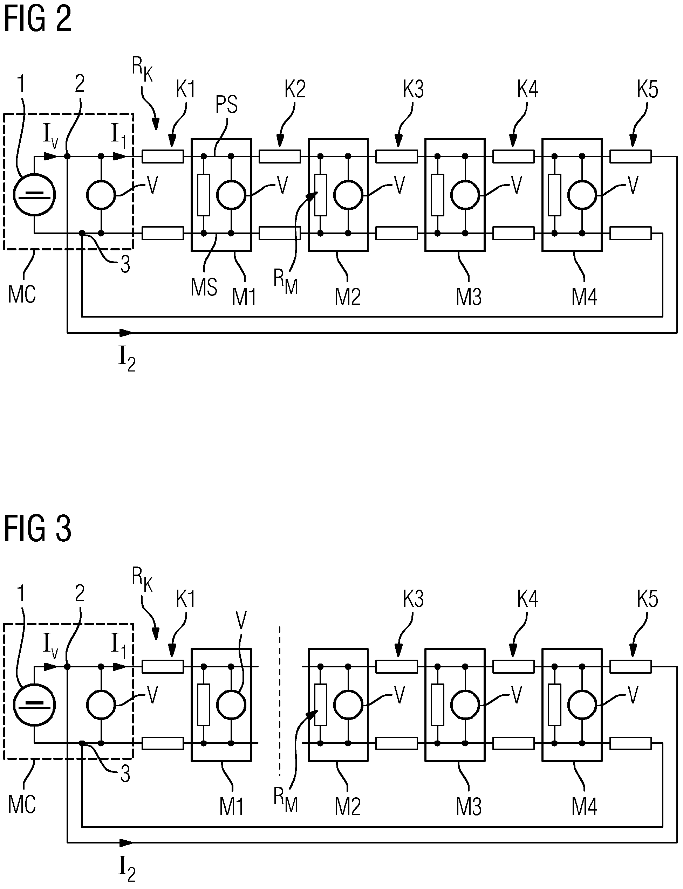

In dem Beispiel von FIG 2 sind an die Steuerungseinheit MC nur vier Module M1, M2, M3 und M4 über einen ringförmigen Versorgungsbus angeschlossen. Alternativ ist der Versorgungsbus nicht an die Steuerungseinheit sondern an eine separate Spannungsquelle bzw. Versorgungseinheit angeschlossen. Die Anzahl der Module pro Bus und die Anzahl der Busse selbst ist natürlich frei wählbar. Der ringförmige Versorgungsbus wird beispielsweise mit Kabeln K1, K2, K3, K4 und K5 sowie mit entsprechenden Leitungen in der Steuerungseinheit MC (im Folgenden stellvertretend auch für eine andere Versorgungseinheit) und den Modulen M1 bis M4 realisiert. Zwischen jeweils zwei Komponenten aus der Menge der Steuerungseinheit MC und den Modulen M1 bis M4 ist jeweils eines der Kabel K1 bis K5 angeordnet.

Zum Zwecke der Erfindung lässt sich jedes Modul M1 bis M4 schematisch durch eine Plusschiene PS und eine Minusschiene MS darstellen. Die beiden Schienen sind über eine Parallelschaltung eines Modulwiderstands R_{M} und eines Spannungsmessers V miteinander gekoppelt.

Beide Schienen PS und MS jedes Moduls M1 bis M4 sind beidseitig mit einem jeweiligen Kabel verbunden. Dabei besitzt jedes Kabel hier jeweils eine Plusader und eine Minusader, welche jeweils durch einen Kabelwiderstand R_{K} repräsentiert werden.

Die Steuerungseinheit MC besitzt eine Hilfsspannungsquelle 1 (die auch als von der Steuerungseinheit separate Versorgungseinheit realisiert sein kann), die einen Versorgungsstrom I_{V} liefert, und ebenfalls einen Spannungsmesser V. Beide sind durch zwei Knoten 2 und 3 parallelgeschaltet. Der erste Knoten 2 ist der Plusschiene aller Module M1 bis M4 zugeordnet und liefert über die Plusader des Kabels K1 einen Strom I₁ an die Plusschiene PS des ersten Moduls M1. Über die Plusadern der Kabel K2, K3 und K4 sind die jeweiligen Plusschienen PS der Module M2, M3 und M4 in Serie an die Plusschiene PS des Moduls 1 geschaltet. Über die Plusader, die wieder durch einen Kabelwiderstand R_{K} repräsentiert wird, ist die Plusschiene PS des vierten Moduls M4 mit dem Knoten 2 der Steuerungseinheit MC verbunden, wodurch auf der Plusseite der Steuerungseinheit MC und der Module M1 bis M4 ein geschlossener Ring entsteht. Vom Knoten 2 fließt ein zweiter Strom I₂ in die Plusader des fünften Kabels K5.

Ein ebenfalls geschlossener Ring ergibt sich auf der Minusseite, wobei der Knoten 3 der Steuerungseinheit MC über Minusadern der Kabel K1 bis K5, die jeweils wieder mit Kabelwiderständen R_{K} repräsentiert sind, in Serie abwechselnd mit den Minusschienen MS der Module M1 bis M4 verbunden ist. Die letzte Minusader, hier die des Kabels K5, ist wieder an den Knoten 3 angeschlossen, um die Ringstruktur zu schließen.

Aufgrund der Ringstruktur würden die Spannungsmesser V der Module M1 und M4 eine etwas geringere Spannung messen als der Spannungsmesser V der Steuerungseinheit MC. Die Spannungswerte der Spannungsmesser V der Module M2 und M3 wären wiederum etwas geringer als diejenigen Werte der Module M1 und M4. Alle Spannungsmesser der Module M1 bis M4 liefern über einen oder mehrere Kommunikationskanäle, die der Übersicht halber in FIG 2 nicht eingezeichnet sind, ihre Spannungswerte an die zentrale Steuerungseinheit MC. Diese kann die aktuell gemessenen Spannungswerte beispielsweise mit in ihr hinterlegten Sollwerten oder Schwellwerten vergleichen. Gegebenenfalls wird der Vergleich mit Toleranzbändern durchgeführt.

In aller Regel ist ohnehin eine Überwachung der Versorgungsspannungen der einzelnen Module notwendig. Damit liegt eine entsprechende Spannungsinformation für jedes Modul ohnehin vor. Diese Spannungsinformation wird nun nicht nur intern auf gewisse Schwellen überprüft und zu einem Fehler oder einer Warnung zusammengefasst, sondern auch als Spannungswert extern an die zentrale Steuerungseinheit MC gemeldet. Dort liegen somit alle aktuellen Modulspannungen vor. Durch die Kabelimpedanz und die vom jeweiligen Modul benötigte Leistung, die in FIG 2 mit einem Widerstand R_{M} abgebildet ist, ergibt sich entlang des Versorgungsbusses ein Spannungsabfall, wie er oben beschrieben wurde. Dieser Spannungsabfall kann auf seinen Verlauf hin überprüft werden. Ändert sich der Verlauf des Spannungsabfalls (also die einzelnen Werte der Modulspannungen) während des Betriebs beziehungsweise zeigt der Verlauf untypisches Verhalten, so kann auf einen Kabelbruch und gegebenenfalls die Position des Bruches geschlossen werden.

FIG 3 zeigt den Betrieb des Systems mit Kabelbruch. Hierzu ist in dem Beispiel das Kabel K2 entfernt, was durch eine gestrichelte Linie symbolisiert ist. Dieses Fehlen des Kabels K2 repräsentiert den Kabelbruch. Das Netzwerk und insbesondere jedes einzelne Modul funktioniert weiterhin. Die gewünschte Redundanz, gemäß der jedes Modul von zwei Seiten versorgt ist beziehungsweise nach zwei Seiten kommunizieren kann, ist allerdings erloschen.

In dem in FIG 3 dargestellten Beispielfall wird die Spannung des Moduls M2 gegenüber dem ungestörten Betrieb gemäß FIG 2 sinken, da seine Leistungsaufnahme komplett durch die rechts liegenden Zuleitungen gedeckt werden muss. Im ungestörten Fall wird dieses Modul M2 von beiden Seiten versorgt werden. Die Leitungswiderstände R_{K} sind im ungestörten Fall sozusagen parallelgeschaltet. Der Leitungswiderstand zum entferntesten Modul in dem nun nicht mehr ringförmigen Kommunikationsbus erhöht sich somit gegenüber dem intakten ringförmigen Versorgungsbus. Dies führt zu einem höheren Spannungsabfall und kann an einer ungeregelten Eingangsspannung detektiert werden.

Gleichzeitig steigt in dem Beispiel von FIG 3 die Spannung am Modul M1, da das Kabel K1 nun nur den Strom für Modul M1 tragen muss. Im ungestörten Fall gemäß FIG 2 muss das Kabel K1 anteilig auch die Ströme für die restlichen Module tragen.

Anhand der unterschiedlichen Spannungswerte im ungestörten Fall und bei Kabelbruch kann also auf einen Kabelbruch geschlossen werden. Wenn für sämtliche Fälle des Kabelbruchs (K1, K2, K3, K4 oder K5) jeweilige Spannungswerte in der zentralen Steuerungseinheit MC hinterlegt sind, kann aufgrund der jeweils spezifischen Spannungswerte auch auf den Ort des Kabelbruchs, d.h. das spezifische gebrochene Kabel, geschlossen werden. Dazu kann man sich entweder eines Vergleichs mit Sollwerten oder mit Schwellwerten bedienen.

Der Vorteil der vorliegenden Erfindung liegt also in der intelligenten Verwertung beziehungsweise Auswertung der Betriebs- und Hilfsgrößen von modernen verteilten Systemen. Die erfassten Werte werden nicht nur auf Einhaltung gewisser Grenzen überprüft, sondern an zentraler Stelle ausgewertet. Somit ist es möglich, Kabelbrüche auch bei redundant ausgeführten Systemen zu erkennen. Der potentielle Systemausfall bei erneutem Kabelbruch kann durch eine entsprechende Warnung verhindert werden. Durch eine frühzeitige Erkennung und Eingrenzung solcher Fehler können zudem Offline- und Servicebeziehungsweise Wartungszeiten drastisch verkürzt werden.

## Patentansprüche

1. Modulares, elektronisches System mit
- mehreren Modulen (M11 bis M18, M21 bis M28, M31 bis M38) und
- einer Steuerungseinheit (MC),
**gekennzeichnet durch**
- einen ringförmigen Versorgungsbus (B1 bis B4) zur Versorgung der Module (M11 bis M18, M21 bis M28, M31 bis M38) mit einer Hilfsspannung, wobei
- jedes der Module (M11 bis M18, M21 bis M28, M31 bis M38) einen Spannungsmesser (V) aufweist, der an den Versorgungsbus (B1 bis B4) angeschlossen ist und mit dem ein Spannungswert der Hilfsspannung am jeweiligen Modul erfassbar ist,
- jedes Modul (M11 bis M18, M21 bis M28, M31 bis M38) dazu ausgebildet ist, den jeweiligen Spannungswert an die Steuerungseinheit (MC) zu übertragen, und
- die Steuerungseinheit dazu ausgebildet ist, anhand der Spannungswerte der Module (M11 bis M18, M21 bis M28, M31 bis M38) festzustellen, ob ein Kabel (K1 bis K5) des Versorgungsbusses (B1 bis B4) gebrochen ist.

2. System nach Anspruch 1, wobei die Steuerungseinheit (MC) dazu ausgelegt ist, durch Vergleich eines oder mehrerer der Spannungswerte der Module (M11 bis M18, M21 bis M28, M31 bis M38) mit einem Sollwert festzustellen, ob das Kabel (K1 bis K5) gebrochen ist.

3. System nach Anspruch 1 oder 2, wobei die Steuerungseinheit dazu ausgelegt ist, durch Vergleich der mehreren Spannungswerte mit mehreren Sollwerten festzustellen, an welcher Stelle des Versorgungsbus (B1 bis B4) ein Kabelbruch vorliegt.

4. System nach Anspruch 2 oder 3, wobei der Vergleich mit einem oder mehreren Schwellwerten unter Berücksichtigung eines jeweiligen Toleranzbands erfolgt.

5. System nach Anspruch 1, wobei die Steuerungseinheit (MC) dazu ausgelegt ist, durch Vergleich eines oder mehrerer der Spannungswerte der Module (M11 bis M18, M21 bis M28, M31 bis M38) mit einem Schwellwert festzustellen, ob das Kabel (K1 bis K5) gebrochen ist.

6. System nach Anspruch 1 oder 5, wobei die Steuerungseinheit dazu ausgelegt ist, durch Vergleich der mehreren Spannungswerte mit mehreren Schwellwerten festzustellen, an welcher Stelle des Versorgungsbusses (B1 bis B4) ein Kabelbruch vorliegt.

7. System nach einem der vorhergehenden Ansprüche, wobei der ringförmige Versorgungsbus (B1 bis B4) durch eine abwechselnde Folge von Kabeln (K1 bis K5) und Modulen (M11 bis M18, M21 bis M28, M31 bis M38) realisiert ist, in die an Stelle eines Moduls die Steuerungseinheit eingefügt ist.

8. System nach Anspruch 7, wobei alle Module (M11 bis M18, M21 bis M28, M31 bis M38) untereinander und alle Kabel (K1 bis K5) untereinander gleich sind.

9. System nach einem der vorhergehenden Ansprüche, das als modularer Mehrpunktstromrichter ausgebildet ist.

10. Verfahren zum Betreiben eines verteilten, modularen, elektronischen Systems mit mehreren Modulen (M11 bis M18, M21 bis M28, M31 bis M38), einer Steuerungseinheit und einen ringförmigen Versorgungsbus (B1 bis B4) durch
- Liefern einer Hilfsspannung an die Module (M11 bis M18, M21 bis M28, M31 bis M38) über den Versorgungsbus (B1 bis B4),
- Erfassen eines Spannungswerts der Hilfsspannung an jedem Modul (M11 bis M18, M21 bis M28, M31 bis M38),
- Übertragen des jeweiligen Spannungswerts von jedem Modul (M11 bis M18, M21 bis M28, M31 bis M38) an die Steuerungseinheit und
- Feststellen mittels der Steuerungseinheit anhand der Spannungswerte der Module (M11 bis M18, M21 bis M28, M31 bis M38), ob ein Kabel (K1 bis K5) des Versorgungsbusses (B1 bis B4) gebrochen ist.
